# EUROPEAN PATENT APPLICATION

(11) **EP 4 401 115 A1**
(43) Date of publication of application: **17.07.2024**
(21) Application number: 22869960.9
(22) Date of filing: 13.09.2022
(51) Int. Cl.: H01L 21/304, C09D 9/04, C09J 7/35, C09J 183/05, C09J 183/07, C11D 7/24, C11D 7/32, C11D 7/50, H01L 21/02

(54) **METHOD FOR CLEANING SEMICONDUCTOR SUBSTRATE, METHOD FOR MANUFACTURING PROCESSED SEMICONDUCTOR SUBSTRATE, AND COMPOSITION FOR EXFOLIATION AND DISSOLUTION**

(30) Priority: 16.09.2021 JP 2021151097
(71) Applicant: Nissan Chemical Corporation, Tokyo 103-6119 (JP)
(72) Inventor: YAGYU, Masafumi, Toyama-shi, Toyama 939-2792 (JP); OKUNO, Takahisa, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2022/034149
(87) International publication number: WO 2023/042813

(57) **Abstract**

Provided are a method for cleaning a semiconductor substrate that can cleanly remove (clean) an adhesive layer from a semiconductor substrate having the adhesive layer on a surface thereof in a shorter time by a simple operation, a method for manufacturing a processed semiconductor substrate including such a cleaning method, and a composition used in such a cleaning method. A method for cleaning a semiconductor substrate includes a step of releasing and dissolving an adhesive layer formed on a semiconductor substrate using a releasing and dissolving composition, in which the releasing and dissolving composition contains: a component [I]: a quaternary ammonium salt; a component [II]: an amide-based solvent; and a component [III]: a solvent represented by the following Formula (L). 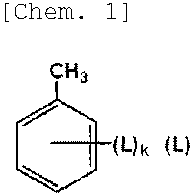 (in the formula, L represents a substituent substituted on a benzene ring and each independently represents an alkyl group having 1 to 4 carbon atoms, and k represents the number of L and is an integer of 0 to 5).

## Description

### Technical Field

The present invention relates to a method for cleaning a semiconductor substrate, a method for manufacturing a processed semiconductor substrate, and a releasing and dissolving composition.

### Background Art

For a semiconductor wafer that has been integrated in a two-dimensional planar direction in the related art, there is a demand for a semiconductor integration technique that integrates (laminates) planes in a three-dimensional direction for the purpose of further integration. The three-dimensional lamination is a technique of laminating layers into a multi-layer while connecting the layers by a through-silicon via (TSV). At the time of multi-layer lamination, each of wafers to be integrated is thinned by polishing on a side opposite to the formed circuit surface (that is, a rear surface), and the thinned semiconductor wafers are laminated.

In order to polish a semiconductor wafer before thinning (also simply referred to herein as a "wafer") with a polishing device, the semiconductor wafer adheres to a support. The adhesion at that time is referred to as temporary adhesion because it should be easily released after polishing. This temporary adhesion should be easily removed from the support, and the thinned semiconductor wafer may be cut or deformed when a large force is applied for removal. Therefore, the semiconductor wafer is easily removed so that such a situation does not occur. However, at the time of polishing the rear surface of the semiconductor wafer, it is not preferable that the semiconductor wafer is detached or displaced due to a polishing stress. Therefore, the performance required for the temporary adhesion is to withstand the stress during polishing and to be easily removed after polishing. For example, there is a demand for performance having a high stress (strong adhesive force) in a planar direction at the time of polishing and a low stress (weak adhesive force) in a direction that intersects with the planar direction, that is, a longitudinal direction at the time of removal. In addition, in a processing step, the temperature may become a high temperature of 150°C or higher, and further, heat resistance is also required.

Under such circumstances, in the semiconductor field, a polysiloxane-based adhesive that can have these performances is mainly used as a temporary adhesive. In addition, in polysiloxane-based adhesion using the polysiloxane-based adhesive, an adhesive residue often remains on a surface of a substrate after a thinned substrate is released, but in order to avoid defects in subsequent steps, a cleaning agent composition for removing the residue and cleaning a surface of a semiconductor substrate has been developed (for example, see Patent Literatures 1 and 2). Patent Literature 1 discloses a siloxane resin removing agent containing a polar aprotic solvent and a quaternary ammonium hydroxide, and Patent Literature 2 discloses a curable resin removing agent containing an alkyl ammonium fluoride. However, in the recent semiconductor field, there is always a demand for a novel cleaning agent composition, and there is always a demand for an effective cleaning agent composition and a cleaning method.

### Citation List

### Patent Literature

Patent Literature 1: WO 2014/092022 A
Patent Literature 2: US 6,818,608

### Summary of Invention

### Technical Problem

The cleaning agent compositions described in Patent Literatures 1 and 2 are intended to remove the adhesive residue from the surface of the substrate by dissolving the adhesive residue on the surface of the substrate, but it has been found that it takes a long time to eliminate the adhesive residue from the surface of the substrate by dissolving as described above.

As a result of conducting studies on a cleaning agent composition, the present inventors have found that when a composition containing a specific component is used, an adhesive layer can be swollen and the adhesive layer can be released from a substrate. When the composition containing a specific component is used, the adhesive layer can be removed from the substrate in a short time.

However, there is room for improvement from the viewpoint of more cleanly removing the adhesive residue from the surface of the substrate in a shorter time by a simple operation, and a novel cleaning method and a composition used for the cleaning method have been developed in search of a more effective cleaning method.

The present invention has been made in view of the above circumstances, and an object of the present invention is to provide a method for cleaning a semiconductor substrate that can cleanly remove (clean) an adhesive layer obtained using, for example, a siloxane-based adhesive from a semiconductor substrate having the adhesive layer on a surface thereof in a shorter time by a simple operation, a method for manufacturing a processed semiconductor substrate including such a cleaning method, and a composition used in such a cleaning method.

### Solution to Problem

As a result of intensive studies to solve the above problems, the present inventors have found that the above problems can be solved by cleaning an adhesive layer formed on a semiconductor substrate, particularly, an adhesive layer which is a cured film obtained using a siloxane-based adhesive containing a polyorganosiloxane component (A') cured by a hydrosilylation reaction using a composition containing a specific component to simultaneously perform swelling, releasing, and dissolving the adhesive layer by one cleaning operation so as to eliminate the adhesive layer from the semiconductor substrate, thereby completing the present invention.

That is, the present invention encompasses the following aspects.
[1] A method for cleaning a semiconductor substrate, the method including a step of releasing and dissolving an adhesive layer formed on a semiconductor substrate using a releasing and dissolving composition,
   in which the releasing and dissolving composition contains:
   a component [I]: a quaternary ammonium salt;
   a component [II]: an amide-based solvent; and
   a component [III]: a solvent represented by the following Formula (L): 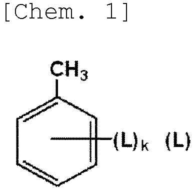
   (in the formula, L represents a substituent substituted on a benzene ring and each independently represents an alkyl group having 1 to 4 carbon atoms, and k represents the number of L and is an integer of 0 to 5).
[2] The method for cleaning a semiconductor substrate according to [1], in which L is a methyl group or an isopropyl group.
[3] The method for cleaning a semiconductor substrate according to [2], in which the solvent represented by Formula (L) is at least one selected from toluene, mesitylene, p-cymene, and 1,2,4-trimethylbenzene.
[4] The method for cleaning a semiconductor substrate according to any one of [1] to [3], in which the quaternary ammonium salt is a halogen-containing quaternary ammonium salt.
[5] The method for cleaning a semiconductor substrate according to any one of [1] to [4], in which the amide-based solvent is an acid amide derivative represented by the following Formula (Z) or a compound represented by the following Formula (Y): 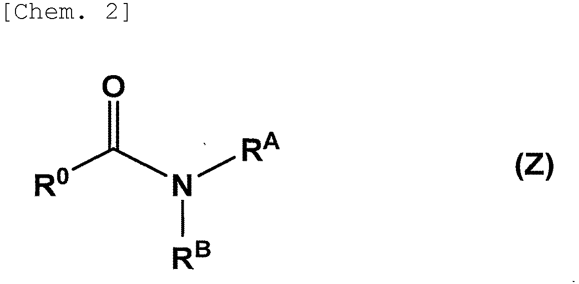
   (in the formula, R° represents an ethyl group, a propyl group, or an isopropyl group, and R^{A} and R^{B} each independently represent an alkyl group having 1 to 4 carbon atoms), 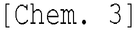 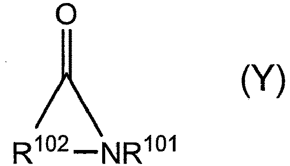
   (in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 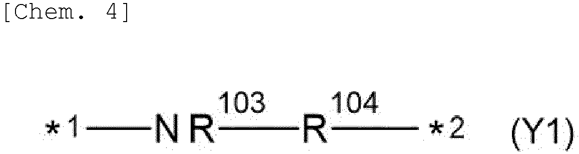
   (in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).
[6] The method for cleaning a semiconductor substrate according to any one of [1] to [5], in which the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[7] The method for cleaning a semiconductor substrate according to [6], in which the adhesive component (S) contains a siloxane-based adhesive.
[8] The method for cleaning a semiconductor substrate according to [7], in which the siloxane-based adhesive contains a polyorganosiloxane component (A') which is cured by a hydrosilylation reaction.
[9] The method for cleaning a semiconductor substrate according to any one of [1] to [8], in which the releasing and dissolving step includes a step of eliminating the released adhesive layer.
[10] A method for manufacturing a processed semiconductor substrate, the method including:
   a first step of manufacturing a laminate including a semiconductor substrate, a support substrate, and an adhesive layer obtained using an adhesive composition;
   a second step of processing the semiconductor substrate of the obtained laminate;
   a third step of separating the semiconductor substrate and the adhesive layer from the support substrate; and
   a fourth step of releasing and dissolving the adhesive layer formed on the semiconductor substrate using a releasing and dissolving composition to remove the adhesive layer,
   in which the releasing and dissolving composition contains:
      a component [I]: a quaternary ammonium salt;
      a component [II]: an amide-based solvent; and
      a component [III]: a solvent represented by the following Formula (L): 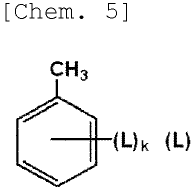
      (in the formula, L represents a substituent substituted on a benzene ring and each independently represents an alkyl group having 1 to 4 carbon atoms, and k represents the number of L and is an integer of 0 to 5).
[11] The method for manufacturing a processed semiconductor substrate according to [10], in which L is a methyl group or an isopropyl group.
[12] The method for manufacturing a processed semiconductor substrate according to [11], in which the solvent represented by Formula (L) is at least one selected from toluene, mesitylene, p-cymene, and 1,2,4-trimethylbenzene.
[13] The method for manufacturing a processed semiconductor substrate according to any one of [10] to [12], in which the quaternary ammonium salt is a halogen-containing quaternary ammonium salt.
[14] The method for manufacturing a processed semiconductor substrate according to any one of [10] to [13], in which the amide-based solvent is an acid amide derivative represented by the following Formula (Z) or a compound represented by the following Formula (Y): 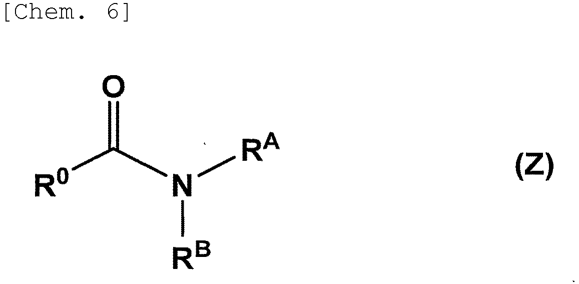
   (in the formula, R° represents an ethyl group, a propyl group, or an isopropyl group, and R^{A} and R^{B} each independently represent an alkyl group having 1 to 4 carbon atoms), 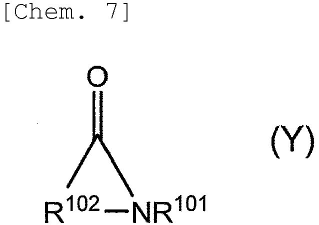
   (in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 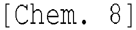 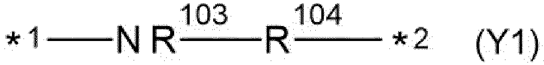
   (in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).
[15] The method for manufacturing a processed semiconductor substrate according to any one of [10] to [14], in which the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[16] The method for manufacturing a processed semiconductor substrate according to [15], in which the adhesive component (S) contains a siloxane-based adhesive.
[17] The method for manufacturing a processed semiconductor substrate according to [16], in which the siloxane-based adhesive contains a polyorganosiloxane component (A') which is cured by a hydrosilylation reaction.
[18] The method for manufacturing a processed semiconductor substrate according to any one of [10] to [17], in which the fourth step of releasing and dissolving the adhesive layer to remove the adhesive layer includes a step of eliminating the released adhesive layer.
[19] A releasing and dissolving composition used for releasing and dissolving an adhesive layer formed on a semiconductor substrate when the semiconductor substrate is cleaned to remove the adhesive layer, the releasing and dissolving composition containing:
   a component [I]: a quaternary ammonium salt;
   a component [II]: an amide-based solvent; and
   a component [III]: a solvent represented by the following Formula (L): 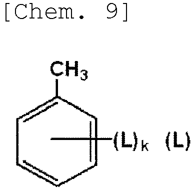
   (in the formula, L represents a substituent substituted on a benzene ring and each independently represents an alkyl group having 1 to 4 carbon atoms, and k represents the number of L and is an integer of 0 to 5).
[20] The releasing and dissolving composition according to [19], in which L is a methyl group or an isopropyl group.
[21] The releasing and dissolving composition according to [20], in which the solvent represented by Formula (L) is at least one selected from toluene, mesitylene, p-cymene, and 1,2,4-trimethylbenzene.
[22] The releasing and dissolving composition according to any one of [19] to [21], in which the quaternary ammonium salt is a halogen-containing quaternary ammonium salt.
[23] The releasing and dissolving composition according to any one of [19] to [22], in which the amide-based solvent is an acid amide derivative represented by the following Formula (Z) or a compound represented by the following Formula (Y): 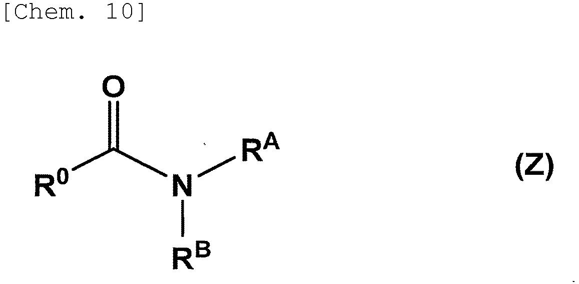
   (in the formula, R° represents an ethyl group, a propyl group, or an isopropyl group, and R^{A} and R^{B} each independently represent an alkyl group having 1 to 4 carbon atoms), 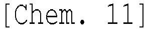 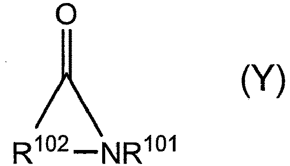
   (in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 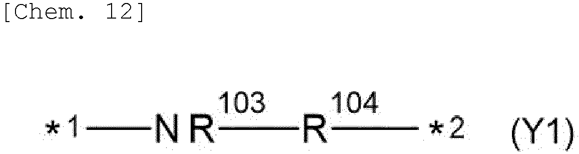
   (in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).
[24] The releasing and dissolving composition according to any one of [19] to [23], in which the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.
[25] The processed releasing and dissolving composition according to [24], in which the adhesive component (S) contains a siloxane-based adhesive.
[26] The releasing and dissolving composition according to [25], in which the siloxane-based adhesive contains a polyorganosiloxane component (A') which is cured by a hydrosilylation reaction.

### Advantageous Effects of Invention

According to the present invention, it is possible to provide a method for cleaning a semiconductor substrate that can cleanly remove (clean) an adhesive layer from a semiconductor substrate having the adhesive layer on a surface thereof in a shorter time by a simple operation, a method for manufacturing a processed semiconductor substrate including such a cleaning method, and a composition used in such a cleaning method.

### Mode for Carrying Out the Invention

Hereinafter, the present invention will be described in detail. Note that the description of the constituent elements described below is an example for describing the present invention, and the present invention is not limited to these contents.

### (Method for Cleaning Semiconductor Substrate)

A method for cleaning a semiconductor substrate of the present invention includes a step of releasing and dissolving an adhesive layer formed on a semiconductor substrate using a releasing and dissolving composition.

The releasing and dissolving composition contains:
a component [I]: a quaternary ammonium salt;
a component [II]: an amide-based solvent; and
a component [III]: a solvent represented by the following Formula (L). 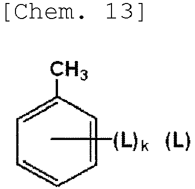
(In the formula, L represents a substituent substituted on a benzene ring and each independently represents an alkyl group having 1 to 4 carbon atoms, and k represents the number of L and is an integer of 0 to 5.)

### <Semiconductor Substrate>

A main material constituting the entire semiconductor substrate is not particularly limited as long as it is used for this type of application, and examples thereof include silicon, silicon carbide, and a compound semiconductor.

A shape of the semiconductor substrate is not particularly limited, and examples thereof include a disk shape. Note that the disk-shaped semiconductor substrate does not need to have a completely circular surface shape, and for example, an outer periphery of the semiconductor substrate may have a straight portion called an orientation flat or may have a cut called a notch.

A thickness of the disk-shaped semiconductor substrate may be appropriately determined according to a purpose of use of the semiconductor substrate and the like, and is not particularly limited, but is, for example, 500 to 1,000 um.

A diameter of the disk-shaped semiconductor substrate may be appropriately determined according to a purpose of use of the semiconductor substrate and the like, and is not particularly limited, but is, for example, 100 to 1,000 mm.

The semiconductor substrate is, for example, a wafer, and specific examples thereof include a silicon wafer having a diameter of about 300 mm and a thickness of about 770 µm, but are not limited thereto.

### <Adhesive Layer>

The adhesive layer formed on the semiconductor substrate is, for example, a film obtained using an adhesive composition containing an adhesive component (S).

Such an adhesive component (S) is not particularly limited as long as it is used for this type of application, and examples thereof include a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

Among them, a siloxane-based adhesive is preferable as the adhesive component (S) because it exhibits preferred adhesive ability during processing of the wafer or the like, can be preferably released after processing, and has excellent heat resistance.

### <<Adhesive Composition>>

In a preferred aspect, the adhesive composition used in the present invention contains a component (A) which is cured by a hydrosilylation reaction as an adhesive component.

In addition, in a preferred aspect, the adhesive composition used in the present invention contains a polyorganosiloxane.

The component (A) may be a component which is cured by a hydrosilylation reaction or a polyorganosiloxane component (A') which is cured by a hydrosilylation reaction.

In another preferred aspect, as an example of the component (A'), the component (A) contains, for example, a polyorganosiloxane (a1) having an alkenyl group having 2 to 40 carbon atoms bonded to silicon atoms, a polyorganosiloxane (a2) having a Si-H group, and a platinum group metal-based catalyst (A2). Here, the alkenyl group having 2 to 40 carbon atoms may be substituted. Examples of a substituent include a halogen atom, a nitro group, a cyano group, an amino group, a hydroxy group, a carboxyl group, an aryl group, and a heteroaryl group.

In still another preferred aspect, the polyorganosiloxane component (A') which is cured by a hydrosilylation reaction contains a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2), and the polysiloxane (A1) contains one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, contains a polyorganosiloxane (a1') containing at least one selected from the group consisting of an M' unit, a D' unit, and a T' unit, and one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and contains a polyorganosiloxane (a2') containing at least one selected from the group consisting of an M" unit, a D" unit, and a T" unit.

Note that (a1') is an example of (a1) and (a2') is an example of (a2).

R¹ to R⁶ are groups or atoms bonded to silicon atoms, and each independently represent an alkyl group which may be substituted, an alkenyl group which may be substituted, or a hydrogen atom. Examples of a substituent include a halogen atom, a nitro group, a cyano group, an amino group, a hydroxy group, a carboxyl group, an aryl group, and a heteroaryl group.

R¹' to R⁶' are groups bonded to silicon atoms, and each independently represent an alkyl group which may be substituted or an alkenyl group which may be substituted, but at least one of R¹' to R⁶' is an alkenyl group which may be substituted. Examples of a substituent include a halogen atom, a nitro group, a cyano group, an amino group, a hydroxy group, a carboxyl group, an aryl group, and a heteroaryl group.

R¹" to R⁶" are groups or atoms bonded to silicon atoms, and each independently represent an alkyl group which may be substituted or a hydrogen atom, but at least one of R¹" to R⁶" is a hydrogen atom. Examples of a substituent include a halogen atom, a nitro group, a cyano group, an amino group, a hydroxy group, a carboxyl group, an aryl group, and a heteroaryl group.

The alkyl group may be a linear, branched, or cyclic alkyl group, but is preferably a linear or branched alkyl group, and the number of carbon atoms thereof is not particularly limited, but is usually 1 to 40, preferably 30 or less, more preferably 20 or less, and still more preferably 10 or less.

Specific examples of the linear or branched alkyl group which may be substituted include, but are not limited to, a methyl group, an ethyl group, an n-propyl group, an i-propyl group, an n-butyl group, an i-butyl group, an s-butyl group, a tert-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n- butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the cyclic alkyl group which may be substituted include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, and bicycloalkyl groups such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 or 6.

The alkenyl group may be a linear, branched, or cyclic alkenyl group, and the number of carbon atoms thereof is not particularly limited, but is usually 2 to 40, preferably 30 or less, more preferably 20 or less, and still more preferably 10 or less.

Specific examples of the linear or branched alkenyl group which may be substituted include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the cyclic alkenyl group which may be substituted include, but are not limited to, cyclopentenyl and cyclohexenyl, and the number of carbon atoms thereof is usually 4 to 14, preferably 5 to 10, and more preferably 5 or 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more kinds of polyorganosiloxanes satisfying such conditions may be used in combination.

Examples of preferred combinations of two or more selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, in a case where two or more kinds of polyorganosiloxanes contained in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more kinds of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms thereof, and a ratio of alkenyl groups in all substituents represented by R¹' to R⁶' is preferably 0.1 to 50.0 mol%, and more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms thereof, and a ratio of hydrogen atoms in all substituents and substituent atoms represented by R¹" to R⁶" is preferably 0.1 to 50.0 mol%, and more preferably 10.0 to 40.0 mol%, and the remaining R¹" to R⁶" can be alkyl groups.

In a case where the component (A) contains (a1) and (a2), in a preferred aspect of the present invention, a molar ratio of the alkenyl group contained in the polyorganosiloxane (a1) and the hydrogen atom constituting the Si-H bond contained in the polyorganosiloxane (a2) is in a range of 1.0:0.5 to 1.0:0.66.

A weight average molecular weight of the polysiloxane such as the polyorganosiloxane (a1) or the polyorganosiloxane (a2) is not particularly limited, but is usually 500 to 1,000,000, and is preferably 5,000 to 50,000 from the viewpoint of realizing the effect of the present invention with excellent reproducibility.

Note that, in the present invention, a weight average molecular weight, a number average molecular weight, and a dispersity of the polyorganosiloxane can be measured, for example, using a GPC apparatus (manufactured by Tosoh Corporation, EcoSEC or HLC-8320GPC) and a GPC column (manufactured by Tosoh Corporation, TSKgel SuperMultiporeHZ-N or TSKgel SuperMultiporeHZ-H) at a column temperature of 40°C, using tetrahydrofuran as an eluent (elution solvent), and using polystyrene (manufactured by Showa Denko K. K., Shodex) as a standard sample at a flow rate of 0.35 mL/min.

A viscosity of each of the polyorganosiloxane (a1) and the polyorganosiloxane (a2) is not particularly limited, but is usually 10 to 1,000,000 (mPa·s), and is preferably 50 to 20,000 (mPa·s) from the viewpoint of realizing the effect of the present invention with excellent reproducibility. Note that the viscosity of each of the polyorganosiloxane (a1) and the polyorganosiloxane (a2) is a value measured at 25°C with an E-type rotational viscometer.

The polyorganosiloxane (a1) and the polyorganosiloxane (a2) react with each other by a hydrosilylation reaction to form a film. Accordingly, a curing mechanism is different from that via, for example, a silanol group, and therefore, any siloxane does not need to have a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, platinum (II) chloride, chloroplatinic acid, a reaction product of chloroplatinic acid and monohydric alcohol, a complex of chloroplatinic acid and olefins, and platinum bisacetoacetate.

Examples of a complex of platinum and olefins include, but are not limited to, a complex of divinyltetramethyldisiloxane and platinum.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

The adhesive composition used in the present invention may further contain a release agent component (B). Such a release agent component (B) is contained in the adhesive composition used in the present invention, such that the obtained adhesive layer can be preferably released with excellent reproducibility.

Typical examples of the release agent component (B) include a polyorganosiloxane. In a preferred aspect, specific examples thereof include, but are not limited to, an epoxy group-containing polyorganosiloxane, a methyl group-containing polyorganosiloxane, and a phenyl group-containing polyorganosiloxane.

In addition, in another preferred aspect, examples of the release agent component (B) include a polydimethylsiloxane, and the polydimethylsiloxane may be modified. Examples of the polydimethylsiloxane which may be modified include, but are not limited to, an epoxy group-containing polydimethylsiloxane, an unmodified polydimethylsiloxane, and a phenyl group-containing polydimethylsiloxane.

A weight average molecular weight of the polyorganosiloxane as the release agent component (B) is not particularly limited, but is usually 100,000 to 2,000,000, and is preferably 200,000 to 1,200,000 and more preferably 300,000 to 900,000 from the viewpoint of realizing the effect of the present invention with excellent reproducibility. In addition, a dispersity thereof is not particularly limited, but is usually 1.0 to 10.0, and is preferably 1.5 to 5.0 and more preferably 2.0 to 3.0 from the viewpoint of realizing preferred releasing with excellent reproducibility. Note that the weight average molecular weight and the dispersity can be measured by the above methods related to the polysiloxane.

A complex viscosity of the polyorganosiloxane as the release agent component (B) can be measured at 25°C using a rheometer (for example, Rheometer MCR-302 manufactured by Anton Paar GmbH).

Examples of the epoxy group-containing polyorganosiloxane include an epoxy group-containing polyorganosiloxane containing a siloxane unit (D¹⁰ unit) represented by R¹¹R¹²S₁O_{2/2}.

R¹¹ is a group bonded to a silicon atom and represents an alkyl group, R¹² is a group bonded to a silicon atom and represents an epoxy group or an organic group containing an epoxy group, and specific examples of the alkyl group include the examples described above.

The epoxy group in the organic group containing an epoxy group may be an independent epoxy group without being fused with other rings, or may be an epoxy group forming a fused ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the siloxane unit (D¹⁰ unit) described above, but may contain a Q unit, an M unit, and/or a T unit in addition to the D¹⁰ unit.

In a preferred aspect of the present invention, specific examples of the epoxy group-containing polyorganosiloxane include a polyorganosiloxane containing only a D¹⁰ unit, a polyorganosiloxane containing a D¹⁰ unit and a Q unit, a polyorganosiloxane containing a D¹⁰ unit and an M unit, a polyorganosiloxane containing a D¹⁰ unit and a T unit, a polyorganosiloxane containing a D¹⁰ unit, a Q unit, and an M unit, a polyorganosiloxane containing a D¹⁰ unit, an M unit, and a T unit, and a polyorganosiloxane containing a D¹⁰ unit, a Q unit, an M unit, and a T unit.

The epoxy group-containing polyorganosiloxane is preferably an epoxy group-containing polydimethylsiloxane having an epoxy value of 0.1 to 5. In addition, a weight average molecular weight thereof is not particularly limited, but is usually 1,500 to 500,000, and is preferably 100,000 or less from the viewpoint of suppressing precipitation in the adhesive.

Specific examples of the epoxy group-containing polyorganosiloxane include, but are not limited to, an epoxy group-containing polyorganosiloxane represented by each of Formulas (E1) to (E3). 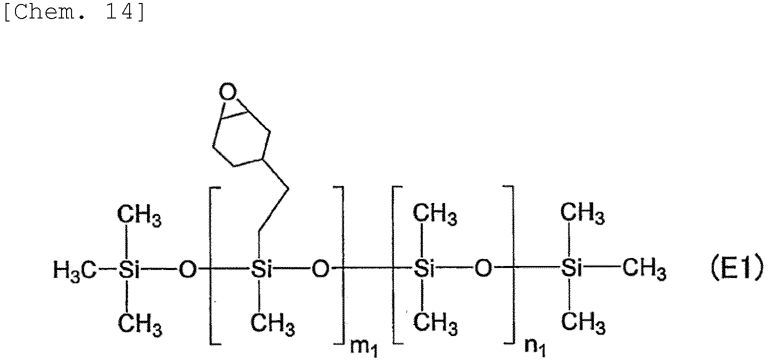 (m₁ and n₁ represent the numbers of repeating units and are positive integers.) 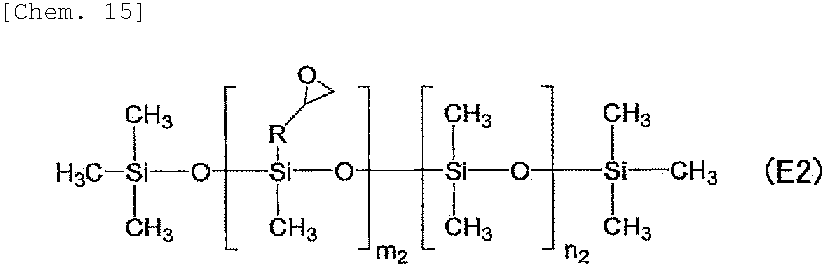 (m₂ and n₂ represent the numbers of repeating units and are positive integers, and R is an alkylene group having 1 to 10 carbon atoms.) 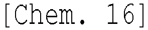 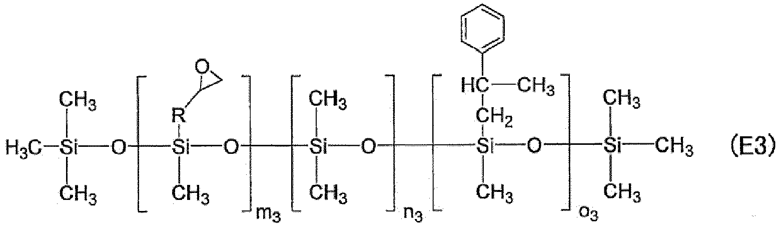 (m₃, n₃, and o₃ represent the numbers of repeating units and are positive integers, and R is an alkylene group having 1 to 10 carbon atoms.)

Examples of the methyl group-containing polyorganosiloxane include a methyl group-containing polyorganosiloxane containing a siloxane unit (D²⁰⁰ unit) represented by R²¹⁰R²²⁰SiO_{2/2}, and preferably a methyl group-containing polyorganosiloxane containing a siloxane unit (D²⁰ unit) represented by R²¹R²¹SiO_{2/2}.

R²¹⁰ and R²²⁰ are groups bonded to silicon atoms, each independently represent an alkyl group, at least one of them is a methyl group, and specific examples of the alkyl group are the examples described above.

R²¹ is a group bonded to a silicon atom and represents an alkyl group, and specific examples of the alkyl group include the examples described above. Among them, R²¹ is preferably a methyl group.

In the present invention, preferred examples of the methyl group-containing polyorganosiloxane include, but are not limited to, a polydimethylsiloxane.

The methyl group-containing polyorganosiloxane contains the siloxane unit (D²⁰⁰ unit or D²⁰ unit) described above, but may contain a Q unit, an M unit, and/or a T unit in addition to the D²⁰⁰ unit and the D²⁰ unit.

In an aspect of the present invention, specific examples of the methyl group-containing polyorganosiloxane include a polyorganosiloxane containing only a D²⁰⁰ unit, a polyorganosiloxane containing a D²⁰⁰ unit and a Q unit, a polyorganosiloxane containing a D²⁰⁰ unit and an M unit, a polyorganosiloxane containing a D²⁰⁰ unit and a T unit, a polyorganosiloxane containing a D²⁰⁰ unit, a Q unit, and an M unit, a polyorganosiloxane containing a D²⁰⁰ unit, an M unit, and a T unit, and a polyorganosiloxane containing a D²⁰⁰ unit, a Q unit, an M unit, and a T unit.

In a preferred aspect of the present invention, specific examples of the methyl group-containing polyorganosiloxane include a polyorganosiloxane containing only a D²⁰ unit, a polyorganosiloxane containing a D²⁰ unit and a Q unit, a polyorganosiloxane containing a D²⁰ unit and an M unit, a polyorganosiloxane containing a D²⁰ unit and a T unit, a polyorganosiloxane containing a D²⁰ unit, a Q unit, and an M unit, a polyorganosiloxane containing a D²⁰ unit, an M unit, and a T unit, and a polyorganosiloxane containing a D²⁰ unit, a Q unit, an M unit, and a T unit.

Specific examples of the methyl group-containing polyorganosiloxane include, but are not limited to, a methyl group-containing polyorganosiloxane represented by of Formula (M1). 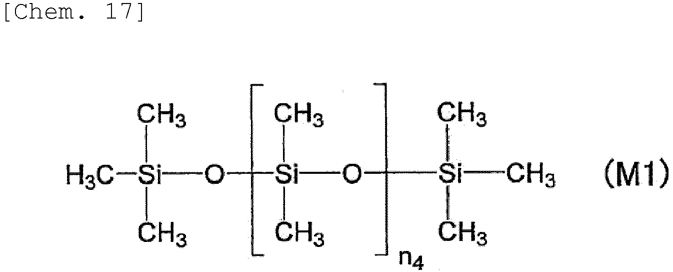 (n₄ represents the number of repeating units and is a positive integer.)

Examples of the phenyl group-containing polyorganosiloxane include a phenyl group-containing polyorganosiloxane containing a siloxane unit (D³⁰ unit) represented by R³¹R³²SiO_{2/2}.

R³¹ is a group bonded to a silicon atom and represents a phenyl group or an alkyl group, and R³² is a group bonded to a silicon atom and represents a phenyl group. Specific examples of the alkyl group include the examples described above, and a methyl group is preferable.

The phenyl group-containing polyorganosiloxane contains the siloxane unit (D³⁰ unit) described above, but may contain a Q unit, an M unit, and/or a T unit in addition to the D³⁰ unit.

In a preferred aspect of the present invention, specific examples of the phenyl group-containing polyorganosiloxane include a polyorganosiloxane containing only a D³⁰ unit, a polyorganosiloxane containing a D³⁰ unit and a Q unit, a polyorganosiloxane containing a D³⁰ unit and an M unit, a polyorganosiloxane containing a D³⁰ unit and a T unit, a polyorganosiloxane containing a D³⁰ unit, a Q unit, and an M unit, a polyorganosiloxane containing a D³⁰ unit, an M unit, and a T unit, and a polyorganosiloxane containing a D³⁰ unit, a Q unit, an M unit, and a T unit.

Specific examples of the phenyl group-containing polyorganosiloxane include, but are not limited to, a methyl group-containing polyorganosiloxane represented by of Formula (P1) or (P2). 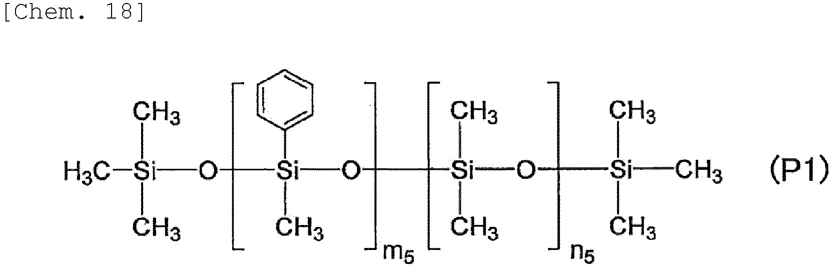 (m₅ and n₅ represent the numbers of repeating units and are positive integers.) 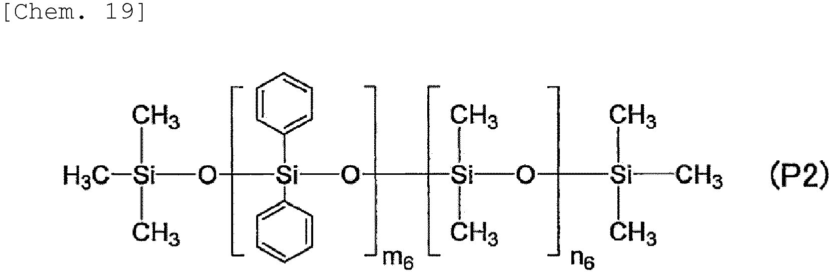 (m₆ and n₆ represent the numbers of repeating units and are positive integers.)

The polyorganosiloxane as the release agent component (B) may be a commercially available product or a synthetic product.

Examples of the commercially available product of the polyorganosiloxane include, but are not limited to, WACKERSILICONE FLUID AK series (AK50, AK 350, AK 1000, AK 10000, and AK 1000000) and GENIOPLAST GUM, which are products manufactured by Wacker Chemie AG, dimethyl silicone oils (KF-96L, KF-96A, KF-96, KF-96H, KF-69, KF-965, and KF-968) and a cyclic dimethyl silicone oil (KF-995) manufactured by Shin-Etsu Chemical Co., Ltd.; epoxy group-containing polyorganosiloxanes (trade names: CMS-227 and ECMS-327) manufactured by Gelest Inc., epoxy group-containing polyorganosiloxanes (KF-101, KF-1001, KF-1005, and X-22-343) manufactured by Shin-Etsu Chemical Co., Ltd., and an epoxy group-containing polyorganosiloxane (BY16-839) manufactured by Dow Corning Corporation; and phenyl group-containing polyorganosiloxanes (PMM-1043, PMM-1025, PDM-0421, and PDM-0821) manufactured by Gelest Inc., a phenyl group-containing polyorganosiloxane (KF50-3000CS) manufactured by Shin-Etsu Chemical Co., Ltd., and phenyl group-containing polyorganosiloxanes (TSF431 and TSF433) manufactured by MOMENTIVE.

The adhesive composition used in the present invention contains a release agent component (B) together with the component (A) which is cured, and in a more preferred aspect, a polyorganosiloxane is contained as the release agent component (B).

As an example, the adhesive composition used in the present invention can contain the component (A) which is cured and the release agent component (B) at any ratio, but in consideration of a balance between adhesiveness and releasability, a ratio of the component (A) which is cured to the release agent component (B) is preferably 99.995:0.005 to 30:70 and more preferably 99.9:0.1 to 75:25 in terms of mass ratio [(A):(B)].

That is, in a case where the polyorganosiloxane component (A') which is cured by a hydrosilylation reaction is contained, a ratio of the component (A') to the release agent component (B) is preferably 99.995:0.005 to 30:70 and more preferably 99.9:0.1 to 75:25 in terms of mass ratio [(A'):(B)].

The adhesive composition used in the present invention may contain a solvent for the purpose of adjusting the viscosity and the like, and specific examples thereof include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone. Such solvents can be used alone or in combination of two or more kinds thereof.

In a case where the adhesive composition used in the present invention contains a solvent, a content thereof is appropriately set in consideration of a desired viscosity of a composition, a coating method to be employed, a thickness of a thin film to be produced, and the like, but is in a range of about 10 to 90 mass% with respect to the entire composition.

A viscosity of the adhesive composition used in the present invention is not particularly limited, but is usually 500 to 20,000 mPa·s and preferably 1,000 to 5,000 mPa·s at 25°C. The viscosity of the adhesive composition used in the present invention can be adjusted by changing a type and a ratio of a solvent to be used, a concentration of film forming components, and the like in consideration of various factors such as a coating method to be used and a desired film thickness.

In the present invention, the film forming component means a component other than the solvent contained in the composition.

As an example, the adhesive composition used in the present invention can be prepared by mixing the component (A) with the release agent component (B) and a solvent when used.

The mixing order is not particularly limited, but examples of a method by which an adhesive composition for releasing can be easily and reproducibly prepared include, but are not limited to, a method in which the component (A) and the release agent component (B) are dissolved in a solvent, and a method in which a part of the component (A) and the release agent component (B) is dissolved in a solvent, the rest is dissolved in the solvent, and the resulting solution is mixed. Note that, when the adhesive composition is prepared, the adhesive composition may be appropriately heated within a range in which the components are not decomposed or degenerated.

In the present invention, for the purpose of removing foreign substances, a solvent, a solution, or the like to be used may be filtered using a filter or the like during the preparation of the adhesive composition or after mixing all the components.

A thickness of the adhesive layer is not particularly limited, but is preferably 10 to 100 µm, and more preferably 20 to 50 um, from the viewpoint of obtaining a preferred releasing effect with excellent reproducibility.

### <Releasing and Dissolving Composition>

The releasing and dissolving composition is a composition used for the method for cleaning a semiconductor substrate in order to eliminate the adhesive layer from the semiconductor substrate.

The releasing and dissolving composition contains a component for swelling the adhesive layer and releasing the adhesive layer from the semiconductor substrate and a component for dissolving the adhesive layer.

Specifically, the releasing and dissolving composition contains:
a component [I]: a quaternary ammonium salt;
a component [II]: an amide-based solvent; and
a component [III]: a solvent represented by the following Formula (L). 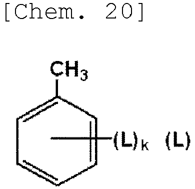
(In the formula, L represents a substituent substituted on a benzene ring and each independently represents an alkyl group having 1 to 4 carbon atoms, and k represents the number of L and is an integer of 0 to 5.)

### <<Component [I]: Quaternary Ammonium Salt>>

The quaternary ammonium salt is composed of a quaternary ammonium cation and an anion, and is not particularly limited as long as it is used for this type of application.

The quaternary ammonium salt is effective as a component for dissolving the adhesive layer.

Examples of such a quaternary ammonium cation typically include tetra(hydrocarbon)ammonium cations. On the other hand, examples of an anion paired therewith include, but are not limited to, a hydroxide ion (OH⁻); halogen ions such as a fluorine ion (F⁻), a chlorine ion (Cl⁻), a bromine ion (Br⁻), and an iodine ion (I⁻); a tetrafluoroborate ion (BF₄⁻); and a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in the tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride includes tetraalkylammonium fluoride.

Specific examples of the tetraalkylammonium fluoride include, but are not limited to, tetramethylammonium fluoride, tetraethylammonium fluoride, tetrapropylammonium fluoride, and tetrabutylammonium fluoride (also referred to as tetrabutylammonium fluoride). Among them, tetrabutylammonium fluoride is preferable.

A quaternary ammonium salt such as tetra(hydrocarbon)ammonium fluoride may be used as a hydrate. In addition, quaternary ammonium salts such as tetra(hydrocarbon)ammonium fluoride may be used alone or in combination of two or more kinds thereof.

The amount of the quaternary ammonium salt is not particularly limited as long as it dissolves in the solvent contained in the releasing and dissolving composition, and is usually, for example, 0.1 to 5 mass% with respect to the releasing and dissolving composition.

### <<Component [II]: Amide-Based Solvent>>

The amide-based solvent is effective as a component for preferably dissolving the quaternary ammonium salt to obtain a releasing and dissolving composition having excellent uniformity.

The amide-based solvent is preferably an N-substituted amide compound having 4 or more carbon atoms and having no active hydrogen on the nitrogen atom.

Preferred examples of the amide-based solvent include an acid amide derivative represented by the following Formula (Z).

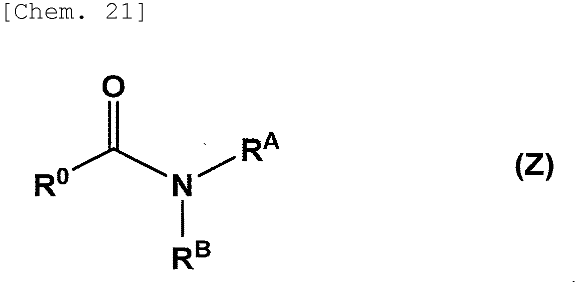

In the formula, R⁰ represents an ethyl group, a propyl group, or an isopropyl group, an ethyl group and an isopropyl group are preferable, and an ethyl group is more preferable. R^{A} and R^{B} each independently represent an alkyl group having 1 to 4 carbon atoms. The alkyl group having 1 to 4 carbon atoms may be a linear, branched, or cyclic alkyl group, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, and both R^{A} and R^{B} are more preferably methyl groups or ethyl groups, and still more preferably methyl groups.

Examples of the acid amide derivative represented by Formula (Z) include N,N-dimethylpropionamide, N,N-diethylpropionamide, N-ethyl-N-methylpropionamide, N,N-dimethyl butyric acid amide, N,N-diethyl butyric acid amide, N-ethyl-N-methyl butyric acid amide, N,N-dimethyl isobutyric acid amide, N,N-diethyl isobutyric acid amide, and N-ethyl-N-methyl isobutyric acid amide. Among them, in particular, N,N-dimethylpropionamide and N,N-dimethylisobutylamide are preferable, and N,N-dimethylpropionamide is more preferable.

The acid amide derivative represented by Formula (Z) may be synthesized by a substitution reaction between a corresponding carboxylic acid ester and an amine, or a commercially available product may be used.

Another preferred example of the amide-based solvent includes a compound represented by Formula (Y) containing a lactam compound or the like.

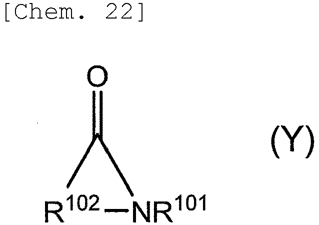

In Formula (Y), R¹⁰¹ represents a hydrogen atom or an alkyl group having 1 to 6 carbon atoms, and R¹⁰² represents an alkylene group having 1 to 6 carbon atoms or a group represented by the following Formula (Y1).

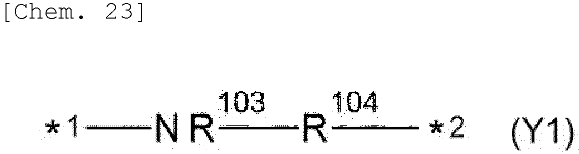

Specific examples of the alkyl group having 1 to 6 carbon atoms of R¹⁰² include, but are not limited to, a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

In Formula (Y1), R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y).

Specific examples of the lactam compound represented by Formula (Y) include an α-lactam compound, a β-lactam compound, a γ-lactam compound, and a δ-lactam compound, and these compounds can be used alone or in combination of two or more thereof.

In a preferred aspect, the lactam compound represented by Formula (Y) contains 1-alkyl-2-pyrrolidone (N-alkyl-γ-butyrolactam), in a more preferred aspect, N-methylpyrrolidone (NMP) or N-ethylpyrrolidone (NEP) is contained, and in a still more preferred aspect, N-methylpyrrolidone (NMP) is contained.

In addition, in a preferred aspect, examples of the compound represented by Formula (Y) include 1,3-dimethyl-2-imidazolidinone.

In the component [II], it is more preferable to use an acid amide derivative represented by Formula (Z) in consideration of an operational restriction based on the regulations on use for chemical substances.

As a content of the amide-based solvent in the releasing and dissolving composition, the content of the amide-based solvent in the releasing and dissolving composition can be 70 mass% or less with respect to 100 mass% of the aprotic solvent.

In addition, the content of the amide-based solvent is preferably 10 to 55 mass%, more preferably 20 to 55 mass%, still more preferably 20 to 45 mass%, and particularly preferably 20 to 40 mass%, with respect to 100 mass% of the aprotic solvent.

Note that, in the present invention, the content of the solvent to be mixed is defined by a ratio when the aprotic solvent that is a solvent having no hydroxyl group (-OH) is 100 mass%.

Therefore, a protic solvent such as water, methanol, or 1-methoxy-2-propanol is not contained based on a content ratio.

In the present invention, the aprotic solvent refers to, for example, N,N-dimethylpropionamide or mesitylene, and a mixing ratio thereof can be determined based on the total amount thereof.

### <<Component [III]: Solvent Represented by Formula (L)>>

The solvent represented by the following Formula (L) is effective as a component for swelling the adhesive layer and releasing the adhesive layer from the semiconductor substrate.

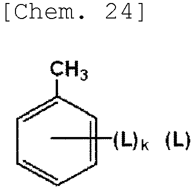

In the formula (L), L represents a substituent substituted on a benzene ring and each independently represents an alkyl group having 1 to 4 carbon atoms, and k represents the number of L and is an integer of 0 to 5.

The alkyl group may be a linear, branched, or cyclic alkyl group, and is preferably a linear or branched alkyl group.

Specific examples of the linear or branched alkyl group include, but are not limited to, a methyl group, an ethyl group, an n-propyl group, an i-propyl group, an n-butyl group, an i-butyl group, an s-butyl group, and a t-butyl group.

Specific examples of the cyclic alkyl group include, but are not limited to, a cyclopropyl group, a cyclobutyl group, a 1-methyl-cyclopropyl group, and a 2-methyl-cyclopropyl group.

From the viewpoint of realizing the releasing of the adhesive layer in a shorter time with excellent reproducibility and the ease of obtaining the compound, L is preferably a methyl group or an isopropyl group.

From the viewpoint of realizing the releasing of the adhesive layer in a shorter time with excellent reproducibility and the ease of obtaining the compound, k is preferably 4 or less, more preferably 3 or less, and still more preferably 2 or less.

From the viewpoint of realizing the releasing of the adhesive layer in a shorter time with excellent reproducibility and the ease of obtaining the compound, preferred examples of an organic solvent represented by Formula (L) include toluene, mesitylene, p-cymene, and 1,2,4-trimethylbenzene.

As the content of the solvent represented by Formula (L) in the releasing and dissolving composition, the content of the solvent in the releasing and dissolving composition is preferably 30 to 90 mass%, and more preferably 40 to 80 mass%, with respect to 100 mass% of the aprotic solvent.

### <<Releasing and Dissolving Step>>

In the present invention, the releasing and dissolving composition is continuously brought into contact with the adhesive layer formed on the semiconductor substrate. This cleaning operation is performed, such that swelling and releasing of the adhesive layer and dissolving of the adhesive layer are simultaneously performed. The swelling, releasing, and dissolving of the adhesive layer are simultaneously performed by one cleaning operation using the cleaning composition, such that the adhesive layer can be removed (cleaned) form the semiconductor substrate more clearly in a shorter time by a simple cleaning operation.

Note that, in the present invention, the removal (cleaning) means that the adhesive layer is eliminated from the semiconductor substrate, and both a case where the adhesive layer is swollen and released from the semiconductor substrate and a case where the adhesive layer dissolves in the solution to disappear from the semiconductor substrate are included in the "removal (cleaning)".

The method for continuously bring the adhesive layer formed on the semiconductor substrate into contact with the releasing and dissolving composition is not particularly limited as long as the adhesive layer formed on the semiconductor substrate is brought into contact with the releasing and dissolving composition with a temporal continuity, and the temporal continuity includes a case where the adhesive layer is brought into contact with the releasing and dissolving composition, a case where, after the contact between the adhesive layer and the organic solvent is performed for a certain period of time, the contact is temporarily suspended, and the contact is performed again or repeated, a case where the entire adhesive layer formed on the semiconductor substrate is brought into contact with the releasing and dissolving composition, and a case where a part of the adhesive layer is brought into contact with the releasing and dissolving composition, but from the viewpoint of realizing more effective cleaning with excellent reproducibility, an aspect in which the adhesive layer formed on the semiconductor substrate is always brought into contact with the releasing and dissolving composition is preferable, and an aspect in which the entire adhesive layer formed on the semiconductor substrate is brought into contact with the releasing and dissolving composition is preferable.

Therefore, in a preferred aspect of the present invention, the adhesive layer formed on the semiconductor substrate is swollen and dissolved by immersing the adhesive layer in the releasing and dissolving composition and the adhesive layer is removed from the semiconductor substrate, or the adhesive layer formed on the semiconductor substrate is swollen and dissolved by continuously supplying the releasing and dissolving composition onto the adhesive layer and the adhesive layer is removed from the semiconductor substrate.

In order to immerse the adhesive layer formed on the semiconductor substrate in the releasing and dissolving composition, for example, the semiconductor substrate with the adhesive layer may be immersed in the releasing and dissolving composition.

An immersion time is a time until swelling and dissolving of the adhesive layer occur and the adhesive layer is released from the semiconductor substrate, and is not particularly limited, but is 5 seconds or longer from the viewpoint of realizing more effective cleaning with excellent reproducibility, and is 5 minutes or shorter from the viewpoint of throughput in the process.

When the adhesive layer formed on the semiconductor substrate is immersed in the releasing and dissolving composition, the removal (cleaning) of the adhesive layer may be promoted by moving the semiconductor substrate with the adhesive layer in the releasing and dissolving composition, subjecting the releasing and dissolving composition to convection, vibrating the releasing and dissolving composition by ultrasonic waves, or the like.

In order to move the semiconductor substrate with the adhesive layer in the releasing and dissolving composition, for example, a swing cleaning machine, a paddle-type cleaning machine, or the like may be used, and when such a cleaning machine is used, a table on which the semiconductor substrate with the adhesive layer is placed moves or rotates vertically or horizontally, such that the adhesive layer formed on the semiconductor substrate is relatively subjected to convection, or the adhesive layer formed on the semiconductor substrate is subjected to convection generated by its the movement or rotation. Therefore, not only the swelling and dissolving of the adhesive layer formed on the semiconductor substrate, but also the releasing and dissolving of the adhesive layer from the semiconductor substrate are promoted.

In order to subject the releasing and dissolving composition to convection, for example, in a state where the semiconductor substrate with the adhesive layer is fixed to a stage or the like, a convection cleaning machine capable of realizing a state in which convection of the releasing and dissolving composition around the semiconductor substrate is performed by a stirrer may be typically used in addition to the swing cleaning machine and the paddle-type cleaning machine described above.

In order to vibrate the releasing and dissolving composition by ultrasonic waves, an ultrasonic cleaning machine or an ultrasonic probe may be used, and the conditions thereof are usually 20 kHz to 5 MHz.

In order to continuously supply the releasing and dissolving composition onto the adhesive layer formed on the semiconductor substrate, the releasing and dissolving composition may be continuously applied toward the adhesive layer formed on the semiconductor substrate. As an example, in a case where the adhesive layer formed on the semiconductor substrate faces upward, for example, a rod-like or atomized, and preferably rod-like releasing and dissolving composition is continuously supplied onto the adhesive layer formed on the semiconductor substrate from above (including obliquely above) the adhesive layer formed on the semiconductor substrate by a nozzle of a cleaning machine or the like. The temporal continuity in this case includes not only a case where the releasing and dissolving composition is always supplied onto the adhesive layer formed on the semiconductor substrate, but also, for example, a case where the supply of the releasing and dissolving composition is stopped once after the supply is performed for a certain period of time, and the supply is performed again, or a case where the supply is repeated. From the viewpoint of realizing more effective cleaning with excellent reproducibility, it is preferable that the releasing and dissolving composition is always supplied onto the adhesive layer formed on the semiconductor substrate.

When the releasing and dissolving composition is supplied in a rod shape onto the adhesive layer formed on the semiconductor substrate, a flow rate thereof is usually 200 to 500 mL/min.

In an aspect of the present invention, in order to realize a state of always being brought into contact with the releasing and dissolving composition, the adhesive layer formed on the semiconductor substrate may be brought into contact with steam of the releasing and dissolving composition by using, for example, a steam cleaning machine.

When the method for cleaning a semiconductor of the present invention is used, as described above, the swelling, releasing, and dissolving of the adhesive layer are simultaneously performed, such that the adhesive layer can be removed (cleaned) form the semiconductor substrate more clearly in a shorter time by a simple cleaning operation. However, in addition to this effect, the damage of the dicing tape in the cleaning step can be prevented by using the method for cleaning a semiconductor of the present invention.

For example, after the semiconductor wafer is polished and thinned, the thinned semiconductor wafer is mounted on the dicing tape, and then the semiconductor wafer and the support are separated (released). After the support is separated (released), the adhesive layer remaining on the semiconductor wafer is eliminated from the semiconductor wafer, and thus cleaned with the cleaning agent composition. In this case, when a cleaning agent composition of a type that dissolves and eliminates an adhesive residue like the cleaning agent compositions of Patent Literatures 1 and 2 is used as the cleaning agent composition, a surface of the dicing tape is changed, and the dicing tape is damaged (see the result of [Comparative Example 2-1] described in the section of Examples below).

However, when the semiconductor substrate with the adhesive layer is cleaned using the releasing and dissolving composition of the present invention, the adhesive layer can be almost released in a short time, and a small amount of the adhesive later remaining after the releasing is also dissolved by the component dissolved in the releasing and dissolving composition, such that the entire removal (cleaning) time for eliminating the adhesive layer can be shortened, and the damage on the dicing tape in the cleaning step can be effectively prevented. In addition, it is considered that the releasing and dissolving composition of the present invention contains not only a component for dissolving the adhesive layer but also a component for swelling and releasing the adhesive layer, such that a proportion of the dissolving component, that is, the component [I] (quaternary ammonium salt) in the composition can be reduced, which also effectively contributes to preventing the dicing tape from being damaged.

When the step of removing the adhesive layer using the releasing and dissolving composition of the present invention is performed, the damage of the dicing tape can be effectively prevented (see the result of [Example 3-1] described in the section of Examples below).

The method for cleaning a semiconductor substrate of the present invention may include a step of eliminating the released adhesive layer.

A method for eliminating the released adhesive layer is not particularly limited as long as the adhesive layer released from the semiconductor substrate is removed, and in a case where the semiconductor substrate with the adhesive layer is immersed in the releasing and dissolving composition, the released adhesive layer present in the releasing and dissolving composition may be eliminated without taking out the semiconductor substrate from the releasing and dissolving composition. Alternatively, the semiconductor substrate may be taken out from the releasing and dissolving composition, and the released adhesive layer may be eliminated by detaching the semiconductor substrate from the released adhesive layer. In this case, the semiconductor substrate is simply taken out from the releasing and dissolving composition, such that the released adhesive layer can naturally remain in the releasing and dissolving composition and most of the adhesive layer can be eliminated.

Specific examples of the method for eliminating the released adhesive layer include, but are not limited to, a method for eliminating the released adhesive layer by adsorbing and sucking the adhesive layer using a device, a method for eliminating the released adhesive layer by blowing off the adhesive layer with gas such as an air gun, and a method for eliminating the released adhesive layer by centrifugal force or the like by moving or rotating the semiconductor substrate vertically or horizontally.

After the adhesive layer released from the semiconductor substrate is removed, if necessary, the semiconductor substrate is dried or the like according to a conventional method.

### (Releasing and Dissolving Composition)

The releasing and dissolving composition used in the method for cleaning a semiconductor substrate of the present invention is also an object of the present invention.

The releasing and dissolving composition of the present invention is used for removing (cleaning) the adhesive layer formed on the semiconductor substrate from the semiconductor substrate, and preferred aspects and conditions are as described above. The releasing and dissolving composition of the present invention can be prepared by mixing the solvents constituting the composition in any order, if necessary. In this case, if necessary, filtration or the like may be performed.

### (Method for Manufacturing Processed Semiconductor Substrate)

The method for cleaning a semiconductor substrate of the present invention described above is used, such that it is possible to efficiently eliminate the adhesive layer formed on the substrate of the semiconductor substrate, particularly, the adhesive layer which is a cured film obtained using a siloxane-based adhesive containing a polyorganosiloxane component (A') cured by a hydrosilylation reaction, and it can be expected to manufacture an excellent semiconductor element with high efficiency.

In the method for manufacturing a processed semiconductor substrate of the present invention, for example, after a semiconductor wafer is polished and thinned, a support is separated (released) from the processed semiconductor wafer after thinning, and then an adhesive layer remaining on the semiconductor wafer is removed (cleaned) by using the method for cleaning a semiconductor substrate of the present invention, such that a processed semiconductor substrate having a cleaned surface without the remaining adhesive layer can be manufactured.

As described above, examples of use of the method for cleaning a semiconductor substrate of the present invention in a semiconductor process include use in a method for manufacturing a processed semiconductor substrate such as thinning used in a semiconductor package technique such as TSV.

In addition to the silicon semiconductor substrate such as the silicon wafer described above, examples of the semiconductor substrate to be cleaned by the cleaning method of the present invention include various substrates such as a germanium substrate, a gallium-arsenic substrate, a gallium-phosphorus substrate, a gallium-arsenic-aluminum substrate, an aluminum-plated silicon substrate, a copper-plated silicon substrate, a silver-plated silicon substrate, a gold-plated silicon substrate, a titanium-plated silicon substrate, a silicon nitride film-formed silicon substrate, a silicon oxide film-formed silicon substrate, a polyimide film-formed silicon substrate, a glass substrate, a quartz substrate, a liquid crystal substrate, and an organic EL substrate.

As a preferred embodiment of the method for manufacturing a processed semiconductor substrate of the present invention, a method for manufacturing a processed semiconductor substrate is exemplified,
the method including:
a first step: a step of manufacturing a laminate including a semiconductor substrate, a support substrate, and an adhesive layer obtained using an adhesive composition;
a second step: a step of processing the semiconductor substrate of the obtained laminate;
a third step: a step of separating the semiconductor substrate and the adhesive layer from the support substrate; and
a fourth step: a step of releasing and dissolving the adhesive layer formed on the semiconductor substrate using a releasing and dissolving composition to remove the adhesive layer.

Here, the releasing and dissolving composition is as described in the section of <Releasing and dissolving Composition> above.

In the fourth step, the method for cleaning a semiconductor substrate of the present invention is used.

Hereinafter, each step will be described in detail.

### <First Step>

As the adhesive composition used for forming the adhesive layer in the first step, the various adhesives described can be used, but the method for cleaning a semiconductor substrate of the present invention is effective for eliminating an adhesive layer obtained using a polysiloxane-based adhesive, and is more effective for eliminating an adhesive layer obtained using a polysiloxane-based adhesive containing a component (A) which is cured by a hydrosilylation reaction.

Therefore, an example in which the adhesive layer is eliminated by the cleaning method of the present invention when a processed semiconductor substrate is manufactured using an adhesive layer obtained using a polysiloxane-based adhesive (adhesive composition) will be described below, but the present invention is not limited thereto.

The first step of manufacturing a laminate including a semiconductor substrate, a support substrate, and an adhesive layer obtained using an adhesive composition will be described below.

In an aspect, the first step includes a step of applying an adhesive composition to a surface of a semiconductor substrate or a support substrate to form an adhesive coating layer, and a step of bonding the semiconductor substrate and the support substrate with the adhesive coating layer therebetween, bringing the semiconductor substrate and the support substrate into close contact with each other by applying a load in a thickness direction while performing at least one of a heat treatment and a decompression treatment, and then performing a post-heat treatment to form a laminate.

In another aspect, the first step includes, for example, a step of applying an adhesive composition to a circuit surface of a wafer formed on a semiconductor substrate and heating the adhesive composition to form an adhesive coating layer, a step of applying a release agent composition to a surface of a support substrate and heating the release agent composition to form a release agent coating layer, and a step of bringing the adhesive coating layer of the semiconductor substrate and the release agent coating layer of the support substrate into close contact with each other by applying a load in a thickness direction while performing at least one of a heat treatment and a decompression treatment, and then performing a post-heat treatment to form a laminate. Note that, although the adhesive composition and the release agent composition are applied to the semiconductor substrate and the support substrate, respectively, and the adhesive composition and the release agent composition are heated, the adhesive composition and the release agent composition may be sequentially applied and heated to either one of the substrates.

In each of the above aspects, which treatment conditions of the heat treatment, decompression treatment, and combination use of both are adopted is determined in consideration of various circumstances such as the type of the adhesive composition, the specific composition of the release agent composition, the compatibility of the films obtained using both compositions, the film thickness, and the required adhesive strength.

Here, for example, the semiconductor substrate is a wafer, and the support substrate is a support. A target to which the adhesive composition is applied may be either one or both of the semiconductor substrate and the support substrate.

Examples of the wafer include, but are not limited to, a silicon wafer or glass wafer having a diameter of about 300 mm and a thickness of about 770 um.

In particular, the method for cleaning a semiconductor substrate of the present invention can effectively clean a semiconductor substrate with bumps as well.

Specific examples of the semiconductor substrate with bumps include a silicon wafer having bumps such as a ball bump, a printed bump, a stud bump, and a plated bump, and usually, the semiconductor substrate with bumps is appropriately selected from conditions of a bump height of about 1 to 200 µm, a bump diameter of 1 to 200 um, and a bump pitch of 1 to 500 um.

Specific examples of the plated bump include, but are not limited to, alloy plating mainly containing Sn, such as SnAg bumps, SnBi bumps, Sn bumps, and AuSn bumps.

The support (carrier) is not particularly limited, and examples thereof include, but are not limited to, a silicon wafer having a diameter of 300 mm and a thickness of about 700 µm.

Examples of the release agent composition include a composition containing a release agent component used for this type of application.

The coating method is not particularly limited, but is usually a spin coating method. Note that a method of separately forming a coating film by a spin coating method or the like and attaching the sheet-like coating film may be adopted, which is also referred to as a coating or coating film.

A heating temperature of the applied adhesive composition varies depending on the type and amount of the adhesive component contained in the adhesive composition, whether or not a solvent is contained, a desired thickness of the adhesive layer, and the like, and thus cannot be generally specified, but the heating temperature is usually 80 to 150°C, and a heating time is usually 30 seconds to 5 minutes.

A heating temperature of the applied release agent composition varies depending on the types and amounts of the crosslinking agent, the acid generator, the acid, and the like, whether or not a solvent is contained, a desired thickness of the release layer, and the like, and thus cannot be generally specified. However, the heating temperature of the applied release agent composition is 120°C or higher from the viewpoint of realizing preferred curing, and is preferably 260°C or lower from the viewpoint of preventing excessive curing, and a heating time is usually 1 to 10 minutes.

The heating can be performed using a hot plate, an oven, or the like.

A thickness of the adhesive coating layer obtained by applying the adhesive composition and heating the adhesive composition is usually 5 to 500 µm.

A thickness of the release agent coating layer obtained by applying the release agent composition and heating the release agent composition is usually 5 to 500 µm.

The heat treatment is appropriately determined from a range of usually 20 to 150°C in consideration of the viewpoint of softening the adhesive coating layer to preferably bond the adhesive coating layer to the release agent coating layer, the viewpoint of preferably curing the release agent coating layer, and the like. In particular, the heating temperature is preferably 130°C or lower and more preferably 90°C or lower from the viewpoint of suppressing and avoiding excessive curing and unnecessary degeneration of the adhesive component and the release agent component, and the heating time is usually 30 seconds or longer and preferably 1 minute or longer from the viewpoint of reliably exhibiting the adhesive ability and the releasability, and is usually 10 minutes or shorter and preferably 5 minutes or shorter from the viewpoint of suppressing degeneration of the adhesive layer or other members.

In the decompression treatment, the semiconductor substrate, the adhesive coating layer, and the support substrate, or the semiconductor substrate, the adhesive coating layer, the release agent coating layer, and the support substrate may be exposed to an atmospheric pressure of 10 to 10,000 Pa. A time for the decompression treatment is usually 1 to 30 minutes.

In a preferred aspect of the present invention, the substrate and the coating layer or the coating layers are preferably bonded to each other by a decompression treatment, and are more preferably bonded to each other by combining a heat treatment and a decompression treatment.

The load in the thickness direction of the semiconductor substrate and the support substrate is not particularly limited as long as the load does not adversely affect the semiconductor substrate and the support substrate and the layer therebetween and can allow the semiconductor substrate and the support substrate to firmly adhere to each other, but is usually within a range of 10 to 1,000 N.

A post-heating temperature is preferably 120°C or higher from the viewpoint of obtaining a sufficient curing rate, and is preferably 260°C or lower from the viewpoint of preventing degeneration of the substrate, the adhesive component, the release agent component, and the like. The heating time is usually 1 minute or longer from the viewpoint of realizing preferred bonding of wafers by curing, and is preferably 5 minutes or longer from the viewpoint of stabilizing the physical properties of the adhesive, and is usually 180 minutes or shorter, and preferably 120 minutes or shorter from the viewpoint of avoiding an adverse effect on the adhesive layer due to excessive heating. The heating can be performed using a hot plate, an oven, or the like.

Note that one object of the post-heating temperature is to more preferably cure the adhesive component (S).

### <Second Step>

Next, the second step of processing the semiconductor substrate of the laminate obtained by the method described above will be described.

Examples of the processing applied to the laminate used in the present invention include processing of the rear surface opposite to the circuit surface of the front surface of the semiconductor substrate, and typically include thinning of the wafer by polishing the rear surface of the wafer. Using such a thinned wafer, a through-silicon via (TSV) or the like is formed, and then the thinned wafer is released from the support to form a laminate of the wafers, and the wafers are three-dimensionally mounted. In addition, before and after that, a wafer rear surface electrode and the like are also formed. Heat of 250 to 350°C is applied to the thinning of the wafer and the TSV process in a state of adhering to the support, and the adhesive layer included in the laminate used in the present invention has heat resistance to the heat.

For example, a wafer having a diameter of about 300 mm and a thickness of about 770 um can be thinned to a thickness of about 80 to 4 um by polishing the rear surface opposite to the circuit surface of the front surface.

### <Third Step>

The third step of separating the processed semiconductor substrate and the adhesive layer from the support substrate will be described.

In the third step, the processed semiconductor substrate and the adhesive layer are separated from the support substrate. At this time, in a case where the release layer is included in the laminate, the release layer is usually eliminated together with the support substrate.

As a method for separating the processed semiconductor substrate and the adhesive layer from the semiconductor substrate, releasing may be performed between the adhesive layer and the release layer or the support substrate in contact therewith, and examples of the releasing method include, but are not limited to, laser releasing, mechanical releasing with equipment having a sharp portion, and manual releasing.

### <Fourth Step>

Next, the fourth step of removing the adhesive layer formed on the processed semiconductor substrate and cleaning the processed semiconductor substrate will be described.

The fourth step is a step of eliminating the adhesive layer formed on the semiconductor substrate by the method for cleaning a semiconductor substrate of the present invention, and specifically, for example, the adhesive layer formed on the thinned substrate is cleanly eliminated in a short time by the cleaning method of the present invention. Various conditions at this time are as described above.

As described above, swelling and dissolving act simultaneously on the adhesive layer only by performing a cleaning operation using the releasing and dissolving composition of the present invention, and thus, in the fourth step, the adhesive layer formed on the semiconductor substrate can be more cleanly removed in a short time.

The method for manufacturing a processed semiconductor substrate of the present invention includes the first step to the fourth step described above, but may include steps other than these steps. In addition, the components and method elements related to the first step to the fourth step may be variously changed without departing from the gist of the present invention.

### Examples

Hereinafter, the content and effect of the present invention will be described in more detail with reference to Examples, but the present invention is not limited thereto. Note that the devices used are as follows.

### [Devices]

(1) Stirrer A: rotation and revolution mixer ARE-500 manufactured by Thinky Corporation
(2) Stirrer B: Mix Rotor VMR-5R manufactured by AS ONE Corporation
(3) Viscometer: rotary viscometer TVE-22H manufactured by Toki Sangyo Co., Ltd.
(4) Optical microscope: semiconductor/FPD inspection microscope MX61L manufactured by Olympus Corporation

### [1] Preparation of Adhesive Composition 1

### [Example 1]

Into a 600 mL stirring vessel dedicated to a stirrer A, 104.14 g of a p-menthane solution (concentration of 80.6 mass%) of an MQ resin (manufactured by Wacker Chemie AG) having a polysiloxane skeleton and a vinyl group as the component (a1), 58.11 g of a polyorganosiloxane represented by the following Formula (M1) (complex viscosity of 800 Pa·s, weight average molecular weight of 171,899 (dispersity of 2.18), manufactured by Wacker Chemie AG) as the component (B), and 34.94 g of p-menthane (manufactured by NIPPON TERPENE CHEMICALS, INC.) and 6.20 g of n-decane (manufactured by SANKYO CHEMICAL CO., LTD.) as solvents were added, and stirring was performed by the stirrer A for 5 minutes, thereby obtaining a mixture (I).

16.79 g of a SiH group-containing linear polydimethylsiloxane (manufactured by Wacker Chemie AG) having a viscosity of 100 mPa·s as the component (a2) and 24.54 g of a vinyl group-containing linear polydimethylsiloxane (manufactured by Wacker Chemie AG) having a viscosity of 200 mPa·s represented by the following Formula (V) as the component (a1) were added to the obtained mixture (I), thereby obtaining a mixture (II).

1.61 g of 1,1-diphenyl-2-propyn-1-ol (manufactured by Tokyo Chemical Industry Co., Ltd.) and 1.61 g of 1-ethynyl-1-cyclohexanol (manufactured by Wacker Chemie AG) as the component (A3), and 3.23 g of p-menthane (manufactured by NIPPON TERPENE CHEMICALS, INC.) as a solvent were stirred with the stirrer B for 60 minutes, thereby obtaining a mixture (III).

1.29 g of the obtained mixture (III) was added to the mixture (II), and stirring was performed with the stirrer A for 5 minutes, thereby obtaining a mixture (IV).

0.65 g of a platinum catalyst (manufactured by Wacker Chemie AG) as the component (A2) and 19.37 g of a vinyl group-containing linear polydimethylsiloxane (manufactured by Wacker Chemie AG) having a viscosity of 1,000 mPa·s represented by the following Formula (W) as the component (a1) were stirred with the stirrer A for 5 minutes, thereby obtaining a mixture (V).

4.00 g of the obtained mixture (V) was added to the mixture (IV), and stirring was performed with the stirrer A for 5 minutes, thereby obtaining a mixture (VI).

Finally, the obtained mixture (VI) was filtered through a nylon filter with 300 mesh to obtain an adhesive composition 1. Note that a viscosity of the obtained adhesive composition 1 was 3,000 mPa·s.

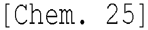

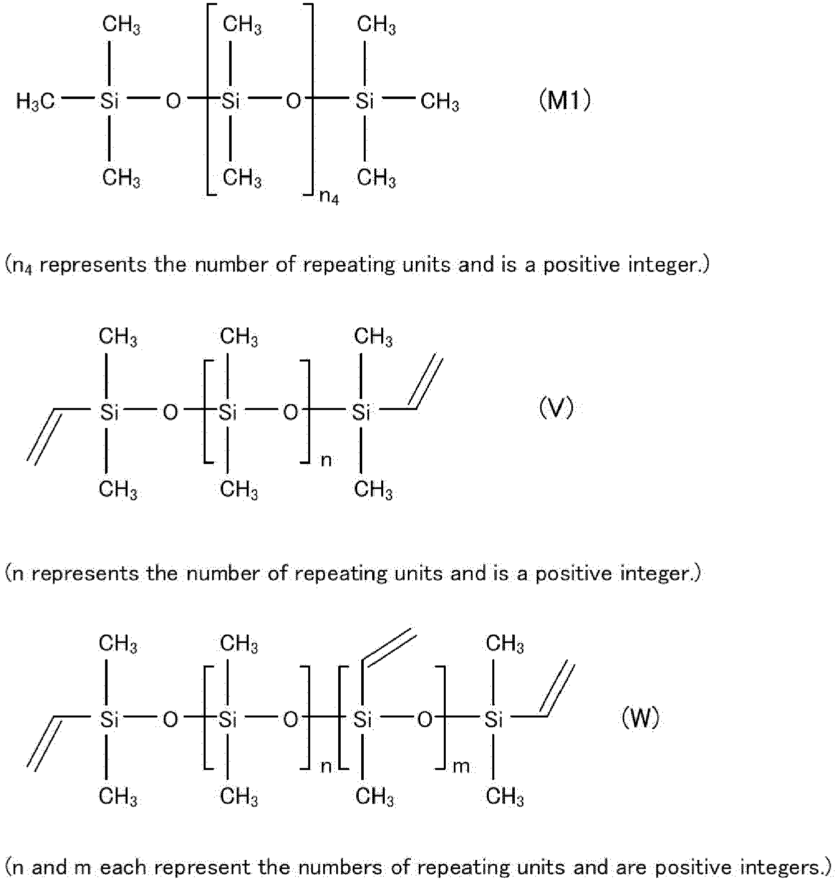

### [2] Preparation of Cleaning Composition

### [Example 2-1]

To 0.77 g of tetrabutylammonium fluoride trihydrate (manufactured by Kanto Chemical Co., Inc.), 7.5 g of N-methyl-2-pyrrolidone and 17.5 g of mesitylene were added, and stirring was performed, thereby obtaining a cleaning composition.

### [Example 2-2]

A cleaning composition was obtained in the same procedure as that of Example 2-1, except that N-ethyl-2-pyrrolidone was used as an N-substituted amide compound of the component II instead of N-methyl-2-pyrrolidone and the composition was adjusted as shown in Table 1.

### [Example 2-3]

A cleaning composition was obtained in the same procedure as that of Example 2-1, except that N,N-dimethylpropionamide was used as the N-substituted amide compound of the component II instead of N-methyl-2-pyrrolidone and the composition was adjusted as shown in Table 1.

### [Example 2-4]

A cleaning composition was were obtained in the same procedure as that of Example 2-1, except that 1,3-dimethyl-2-imidazolidinone was used as the N-substituted amide compound of the component II instead of N-methyl-2-pyrrolidone and the composition was adjusted as shown in Table 1.

### [Comparative Example 1-1]

To 0.85 g of tetrabutylammonium fluoride trihydrate (manufactured by Kanto Chemical Co., Inc.), 27.48 g of N-methyl-2-pyrrolidone was added, and stirring was performed, thereby obtaining a cleaning composition.

### [Comparative Example 1-2]

To 1.3 g of tetrabutylammonium fluoride trihydrate (manufactured by Kanto Chemical Co., Inc.), 24.70 g of N,N-dimethylpropionamide was added, and stirring was performed, thereby obtaining a cleaning composition.

### [3] Manufacturing of Substrate for Evaluation

### [Manufacturing Example 1]

The adhesive composition obtained in Example 1 was applied to a silicon wafer (thickness: 775 µm) of 4 cm × 4 cm as a device-side wafer by spin coating, and heated (preheat treated) at 110°C for 1.5 minutes to remove a residual solvent on the wafer and form a thin film having a thickness of about 40 um on the wafer at 200°C for 10 minutes, thereby obtaining a wafer with an adhesive layer.

### [4] Measurement of Release Time

The wafer with an adhesive layer manufactured in Manufacturing Example 1 was immersed in 7 mL of each of the cleaning compositions obtained in Examples 2-1 to 2-4 and Comparative Examples 1-1 and 1-2. The time until the adhesive layer was completely released from the wafer was taken as a release time. The results are shown in Table 1.

### [5] Confirmation of Presence or Absence of Residue after Releasing

The wafer with an adhesive layer manufactured in Manufacturing Example 1 was immersed in 7 mL of each of the cleaning compositions obtained in Examples 2-1 to 2-4 and Comparative Examples 1-1 and 1-2. In a case where the adhesive layer was released within 2 minutes after immersion in the cleaning composition, the released adhesive layer was removed with tweezers. After allowing the wafer to stand for 2 minutes from the start of immersion, the substrate was washed with isopropanol and ultrapure water, and the presence or absence of a residue on the substrate was confirmed with an optical microscope. The results are shown in Table 1. Note that, in Comparative Examples 1-1 and 1-2, since releasing did not occur even after 300 seconds in the test of [4] above, the test of [5] was not performed (in the table, the expression of "N.A." was used).

### [6] Confirmation of Tape Damage

### [Example 3-1]

DU-300 (manufactured by Nitto Denko Corporation) as a dicing tape was cut into 4 × 4 cm, immersed in 7 mL of the cleaning composition liquid of Example 2-1, and allowed to stand for 5 minutes, the dicing tape was washed with isopropanol and ultrapure water, and a surface of the tape was observed with an optical microscope. As a result, no change was observed on the surface of the tape before and after immersion.

### [Comparative Example 2-1]

DU-300 (manufactured by Nitto Denko Corporation) as a dicing tape was cut into 4 × 4 cm, immersed in 7 mL of the cleaning composition liquid of Comparative Example 1-2, and allowed to stand for 5 minutes, the dicing tape was washed with isopropanol and ultrapure water, and a surface of the tape was observed with an optical microscope. As a result, in the substrate after immersion, an uneven shape was observed on the surface of the tape, and tape damage was confirmed.

It was appreciated that, when the semiconductor substrate with an adhesive layer was cleaned using the releasing and dissolving composition of the present invention, the adhesive layer could be removed (cleaned) from the semiconductor substrate in a short time as shown in Examples 2-1 to 2-4. In the present invention, since the adhesive layer can be almost released in a short time, even when a small amount of the adhesive layer remains after releasing, the adhesive residue is dissolved by the dissolving component in the releasing and dissolving composition, and is cleanly eliminated. This is also shown in the results of Examples 2-1 to 2-4. As shown in Examples 2-1 to 2-4, the adhesive layer formed on the semiconductor substrate could be cleanly eliminated only by immersing the semiconductor substrate in the releasing and dissolving composition of the present invention for a short time of 2 minutes.

That is, when the method for cleaning a semiconductor substrate of the present invention is used, it is possible to more cleanly remove (clean) the adhesive layer from the semiconductor substrate having the adhesive layer on the surface thereof in a shorter time by a simple operation.

In addition, when the method for cleaning a semiconductor substrate of the present invention was used, as shown in [Example 3-1], the dicing tape was not damaged in the step of removing the adhesive layer.

### [Table 1]

**Table. 1**

| | Composition | | | | | | Release time (seconds) | Residue after releasing |
|---|---|---|---|---|---|---|---|---|
| | Component II: N-substituted amide compound (%) | | | | Component III: aromatic hydrocarbon-based (%) | TBAF (phr to total amount of solvent) | | |
| | N-methyl-2-pyrrolidone | N-ethyl-2-pyrrolidone | N,N-dimethylpropionamide | 1,3-dimethyl-2-imidazolidinone | Mesitylene | | | |
| Example 2-1 | 30 | | | | 70 | 3 | 58 | Absent |
| Example 2-2 | | 30 | | | 70 | | 46 | Absent |
| Example 2-3 | | | 30 | | 70 | | 48 | Absent |
| Example 2-4 | | | | 30 | 70 | | 119 | Absent |
| Comparative Example 1-1 | 100 | | | | | | 300< | N.A. |
| Comparative Example 1-2 | | | 100 | | | 5 | 300< | N.A. |

## Claims

1. A method for cleaning a semiconductor substrate, the method comprising a step of releasing and dissolving an adhesive layer formed on a semiconductor substrate using a releasing and dissolving composition,
wherein the releasing and dissolving composition contains:
a component [I]: a quaternary ammonium salt;
a component [II]: an amide-based solvent; and
a component [III]: a solvent represented by the following Formula (L): 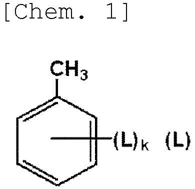
(in the formula, L represents a substituent substituted on a benzene ring and each independently represents an alkyl group having 1 to 4 carbon atoms, and k represents the number of L and is an integer of 0 to 5).

2. The method for cleaning a semiconductor substrate according to claim 1, wherein L is a methyl group or an isopropyl group.

3. The method for cleaning a semiconductor substrate according to claim 2, wherein the solvent represented by Formula (L) is at least one selected from toluene, mesitylene, p-cymene, and 1,2,4-trimethylbenzene.

4. The method for cleaning a semiconductor substrate according to claim 1, wherein the quaternary ammonium salt is a halogen-containing quaternary ammonium salt.

5. The method for cleaning a semiconductor substrate according to claim 1, wherein the amide-based solvent is an acid amide derivative represented by the following Formula (Z) or a compound represented by the following Formula (Y): 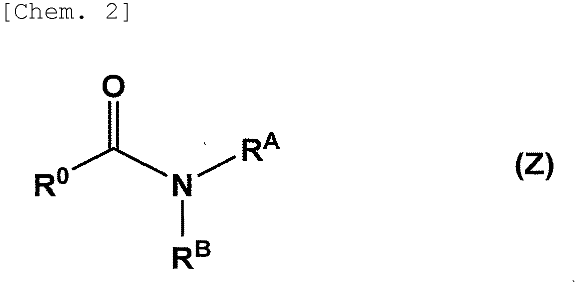
(in the formula, R⁰ represents an ethyl group, a propyl group, or an isopropyl group, and R^{A} and R^{B} each independently represent an alkyl group having 1 to 4 carbon atoms), 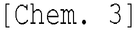 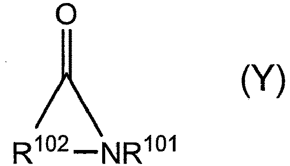
(in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 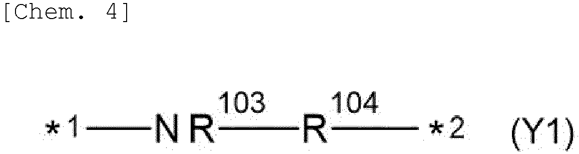
(in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).

6. The method for cleaning a semiconductor substrate according to claim 1, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

7. The method for cleaning a semiconductor substrate according to claim 6, wherein the adhesive component (S) contains a siloxane-based adhesive.

8. The method for cleaning a semiconductor substrate according to claim 7, wherein the siloxane-based adhesive contains a polyorganosiloxane component (A') which is cured by a hydrosilylation reaction.

9. The method for cleaning a semiconductor substrate according to claim 1, wherein the releasing and dissolving step includes a step of eliminating the released adhesive layer.

10. A method for manufacturing a processed semiconductor substrate, the method comprising:
a first step of manufacturing a laminate including a semiconductor substrate, a support substrate, and an adhesive layer obtained using an adhesive composition;
a second step of processing the semiconductor substrate of the obtained laminate;
a third step of separating the semiconductor substrate and the adhesive layer from the support substrate; and
a fourth step of releasing and dissolving the adhesive layer formed on the semiconductor substrate using a releasing and dissolving composition to remove the adhesive layer,
wherein the releasing and dissolving composition contains:
a component [I]: a quaternary ammonium salt;
a component [II]: an amide-based solvent; and
a component [III]: a solvent represented by the following Formula (L): 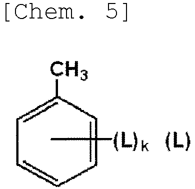
(in the formula, L represents a substituent substituted on a benzene ring and each independently represents an alkyl group having 1 to 4 carbon atoms, and k represents the number of L and is an integer of 0 to 5).

11. The method for manufacturing a processed semiconductor substrate according to claim 10, wherein L is a methyl group or an isopropyl group.

12. The method for manufacturing a processed semiconductor substrate according to claim 11, wherein the solvent represented by Formula (L) is at least one selected from toluene, mesitylene, p-cymene, and 1,2,4-trimethylbenzene.

13. The method for manufacturing a processed semiconductor substrate according to claim 10, wherein the quaternary ammonium salt is a halogen-containing quaternary ammonium salt.

14. The method for manufacturing a processed semiconductor substrate according to claim 10, wherein the amide-based solvent is an acid amide derivative represented by the following Formula (Z) or a compound represented by the following Formula (Y): 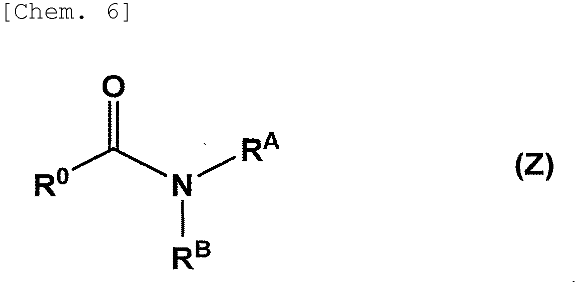
(in the formula, R⁰ represents an ethyl group, a propyl group, or an isopropyl group, and R^{A} and R^{B} each independently represent an alkyl group having 1 to 4 carbon atoms), 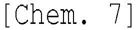 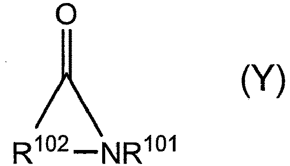
(in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 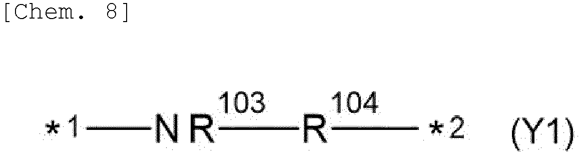
(in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).

15. The method for manufacturing a processed semiconductor substrate according to claim 10, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

16. The method for manufacturing a processed semiconductor substrate according to claim 15, wherein the adhesive component (S) contains a siloxane-based adhesive.

17. The method for manufacturing a processed semiconductor substrate according to claim 16, wherein the siloxane-based adhesive contains a polyorganosiloxane component (A') which is cured by a hydrosilylation reaction.

18. The method for manufacturing a processed semiconductor substrate according to claim 10, wherein the fourth step of releasing and dissolving the adhesive layer to remove the adhesive layer includes a step of eliminating the released adhesive layer.

19. A releasing and dissolving composition used for releasing and dissolving an adhesive layer formed on a semiconductor substrate when the semiconductor substrate is cleaned to remove the adhesive layer, the releasing and dissolving composition comprising:
a component [I]: a quaternary ammonium salt;
a component [II]: an amide-based solvent; and
a component [III]: a solvent represented by the following Formula (L): 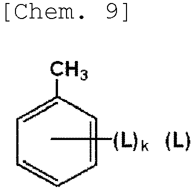
(in the formula, L represents a substituent substituted on a benzene ring and each independently represents an alkyl group having 1 to 4 carbon atoms, and k represents the number of L and is an integer of 0 to 5).

20. The releasing and dissolving composition according to claim 19, wherein L is a methyl group or an isopropyl group.

21. The releasing and dissolving composition according to claim 20, wherein the solvent represented by Formula (L) is at least one selected from toluene, mesitylene, p-cymene, and 1,2,4-trimethylbenzene.

22. The releasing and dissolving composition according to claim 19, wherein the quaternary ammonium salt is a halogen-containing quaternary ammonium salt.

23. The releasing and dissolving composition according to claim 19, wherein the amide-based solvent is an acid amide derivative represented by the following Formula (Z) or a compound represented by the following Formula (Y): 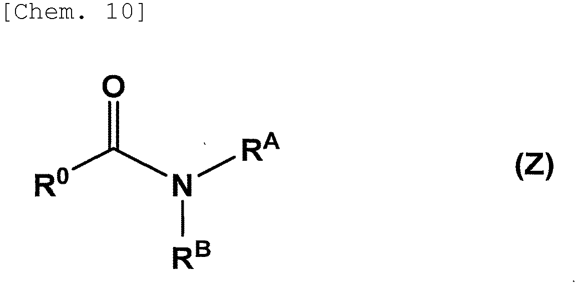
(in the formula, R⁰ represents an ethyl group, a propyl group, or an isopropyl group, and R^{A} and R^{B} each independently represent an alkyl group having 1 to 4 carbon atoms), 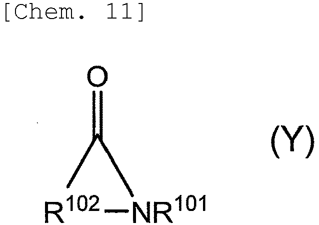
(in the formula, R¹⁰¹ represents a hydrogen atom or an alkyl group having 1 to 6 carbon atoms, and R¹⁰² represents an alkylene group having 1 to 6 carbon atoms or a group represented by the following Formula (Y1)), 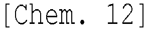 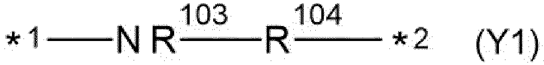
(in the formula, R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in Formula (Y), and *2 represents a bond bonded to a nitrogen atom in Formula (Y)).

24. The releasing and dissolving composition according to claim 19, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenolic resin-based adhesive.

25. The processed releasing and dissolving composition according to claim 24, wherein the adhesive component (S) contains a siloxane-based adhesive.

26. The releasing and dissolving composition according to claim 25, wherein the siloxane-based adhesive contains a polyorganosiloxane component (A') which is cured by a hydrosilylation reaction.
